# EUROPÄISCHE PATENTSCHRIFT

(11) **EP 1 119 918 B1**
(45) Veröffentlichungstag und Bekanntmachung des Hinweises auf die Patenterteilung: **03.12.2003**
(21) Anmeldenummer: 99906042.9
(22) Anmeldetag: 12.01.1999
(51) Int. Cl.: H04B 1/04, H04B 1/40, H03F 3/26

(54) **SENDEENDSTUFE FÜR EIN MOBILTELEFON**
TRANSMISSION POWER AMPLIFIER FOR A MOBILE TELEPHONE
ETAGE DE SORTIE POUR UN TELEPHONE MOBILE

(30) Priorität: 06.10.1998 DE 19846069
(43) Veröffentlichungstag der Anmeldung: 01.08.2001
(73) Patentinhaber: SIEMENS AKTIENGESELLSCHAFT, 80333 München (DE)
(72) Erfinder: MOLIERE, Thomas, D-80805 München (DE)
(86) Internationale Anmeldenummer: DE9900037
(87) Internationale Veröffentlichungsnummer: WO00021202

(56) Entgegenhaltungen:
- US-A- 4 422 047
- US-A- 5 652 546
- US-A- 5 774 017

## Beschreibung

Die Erfindung betrifft eine Sendeendstufe für ein Mobiltelefon und betrifft insbesondere eine Sendestufe für ein solches Mobiltelefon, das für zwei Frequenzbereiche ausgelegt ist. Wenn im folgenden der Einfachheit von Mobiltelefonen gesprochen wird, sollte im Auge behalten werden, dass die Erfindung sich auch für andere (Mehrfrequenz) - Mobiltelefone eignet.

Derzeit sind Mehrband-Mobiltelefone in der Entwicklung bzw. erste Typen am Markt, die auf zwei Betriebsfrequenzen arbeiten können, also in Europa entsprechend den einschlägigen Systemdefinitionen auf 900 MHz und 1800 MHz, während in den USA die Frequenzen 900 MHz und 1900 MHz zum Einsatz kommen.

Erste Entwicklungen arbeiten mit schmalbandigen parallelen Verstärkerketten im Sende- und Empfangsteil. Derartige Dualband-Endstufen haben also für jedes Frequenzband einen auf dieses Band optimierten Verstärker, was mit einem erheblichen Bauteileaufwand und daher mit Kosten und Platzbedarf verbunden ist. Eine derartige Dualband-Endstufe mit getrennten Verstärkerzweigen für jedes Band ist beispielsweise der Baustein TST0911 des Herstellers TEMIC. Beim Einsatz des Bausteins in einem Handy werden die beiden Ausgänge des Bausteins über einen Diplexer auf eine Antenne geführt. Die Nachteile sind auch hier die Kosten und die benötigte Leiterplattenfläche sowie der notwendige Aufwand für die Oberwellenfilterung.

Um Kosten zu senken, wird angestrebt, die beiden Frequenzbänder mit einer Verstärkerkette verarbeitet zu können. So wird in dem Artikel von V. Güngerich, M. Pöbl: "Bessere Handys durch Gallium-Arsenid MMICs", Elektronik 8/1998, S. 90-96, der Aufbau eines Verstärkerchips CGY0819 der Firma Siemens für Mehrfrequenz-Handys beschrieben, der getrennte HF-Eingänge aufweist, wobei die Signale über einen schmalbandigen Verstärker im jeweiligen Band geführt werden und in einer gemeinsamen Endstufe die notwendige Ausgangsleistung erzeugt wird. Die Vorstufen lassen sich dabei je nach Betriebszustand getrennt voneinander aus- und einschalten.

Da der gemeinsame Endverstärker daher sowohl für 900 MHz als auch für 1800 MHz arbeitet, ist er zwangsläufig breitbandig ausgelegt. Daher entsteht zwangsläufig bei 900-MHz-Betrieb eine starke erste Oberwelle bei 1800 MHz. Die Unterdrückung dieser Oberwelle ist nur mit Zusatzfiltern möglich, die eine wesentliche Einfügungsdämpfung des Nutzsignals auf der Grundwelle zur Folge haben und zusätzliche Bauelemente benötigen. Ferner muß eine aufwendige Umschaltung der Anpaßelemente mit Hilfe von Schaltern, beispielsweise PIN-Diodenschalter, oder Diplexfiltern am Ausgang des Sendetransistors vorgenommen werden.

Aus der US-A-4 422 047 (Wright William A) ist eine Sendeendstufe für Funkgeräte bekannt, der auf mehreren Frequenzkanälen arbeitet. Mit Hilfe einer Logikschaltung wird ein Pfad zur Übertragung des Signals durch ein Band-Pass-Filter selektiert, dem eine Gegentaktendstufe folgt, die zur Auswahl der Verstärkung des Sendesignals verwendet wird.

Der Erfindung liegt daher die Aufgabe zugrunde, eine Sendeendstufe für ein Mehrfrequenz-Mobilfunkgerät zu schaffen, die die kritische Umschaltung der Ausgangsanpassung einer Dualband-Sendeendstufe für beide Frequenzbereiche bei gleichzeitig guter Unterdrückung der ersten Oberwelle des niederfrequenteren Signals vereinfacht.

Die Aufgabe wird durch die Merkmale des Anspruchs 1 gelöst. Bevorzugte Ausgestaltungen der Erfindung sind Gegenstand der Unteransprüche.

In einer erfindungsgemäßen Sendeendstufe für ein Mehrfrequenz-Mobiltefefon wird das Sendesignal durch eine Gegentaktendstufe (GTV) erzeugt, und zwar bei einem Betrieb auf mindestens einer niedrigen Frequenz im Gegentaktbetrieb der Gegentaktendstufe, und bei einem Betrieb auf mindestens einer höheren Frequenz im Eintaktbetrieb der Gegentaktendstufe.

Der Eintaktbetrieb kann erzeugt werden, indem das Signal nur von einem Endtransistor ausgekoppelt wird, während der andere Endtransistor gesperrt wird. Ferner kann der Eintaktbetrieb durch Abschalten der Versorgungsspannung oder Sperrung der Transistoren für einen Zweig der Gegentaktendstufe erzielt werden. Es ist auch möglich, daß in einem Zweig des Gegentaktverstärkers ein Schalter angeordnet ist, der ein Kurzschließen dieses Zweigs bewirkt, wenn die Sendeendstufe im Eintaktbetrieb betrieben wird. Vorzugsweise kommt dazu ein PIN-Diodenschalter oder ein FET-Schalter zum Einsatz.

Vorzugsweise weist die Sendeendstufe eine Ausgangsanpasung auf. Ferner kann die Sendeendstufe einen Oberwellenfilter für die niedrige Frequenz und einen Oberwellenfilter für die hohe Frequenz aufweisen, wobei weiterhin die Sendeendstufe einen Schalter aufweist, der entsprechend dem aktuell verwendeten Frequenzband das Signal auf den entsprechenden Oberwellenfilter leitet

Ferner ist in dem Ausgangszweig für die hohe Frequenz ein L-C-Transformator angeordnet, der für eine Anpassung des Lastwiderstands des hochfrequenten Zweiges an die Antennenimpedanz dient.

Vorzugsweise wird in der Sendeendstufe der Ausgang zur Antenne oder zum Antennencombiner für das hochfrequente Band bei Betrieb auf dem niederfrequenten Band gesperrt. Zum Sperren des Ausgangs zur Antenne oder zum Antennencombiner kann ein Schalter eingesetzt werden, der durch einen PIN-Diodenschalter oder ein FET-Schalter realisiert wird.

Vorzugsweise werden als Frequenzen entweder 900 MHz und 1800 MHz oder 900 MHz und 1900 MHz verwendet. Dabei wird der erste Frequenzsatz, nämlich 900 MHz und 1800 MHz, in Europa eingesetzt, während mit dem zweiten Frequenzsatz, d.h. 900 MHz und 1900 MHz, ein Gerät in Europa und USA betriebsbereit ist.

Die Erfindung weist die folgenden Vorteile auf: Durch den Gegentaktbetrieb zur Erzeugung der Ausgangsleistung auf der niedrigeren Frequenz mit einer Gegentaktendstufe ist die erste Oberwelle bereits um 20...30 dB zusätzlich unterdrückt, wodurch der Aufwand zur Oberwellenunterdrückung wesentlich sinkt. Da sich die Leistung auf zwei Transistoren oder Zweige der Gegentaktendstufe aufteilt, ist die gleiche Menge Halbleitermaterial erforderlich wie beim früher üblichen Eintaktbetrieb mit einem Transistor. Bei Betrieb auf der höheren Frequenz wird wie oben erläutert Eintaktbetrieb durchgeführt. Da bei GSM auf der doppelten Frequenz (1800 MHz) nur halb so viel Leistung verlangt wird wie auf der tiefen Frequenz (900 MHz), wird der Transistor (die Transistoren) auf beiden Bändern optimal ausgesteuert. Ferner können bei der erfindungsgemäßen Auslegung der Anpaßschaltung die Anpaßelemente der Gegentaktschaltung für die Eintakt-Auskopplung bei der doppelten Frequenz mitbenutzt werden, wodurch der Schaltungsaufwand weiter verringert wird.

Bevorzugte Ausführungsformen der Erfindung werden nachfolgend anhand der Zeichnungen erläutert.

Fig. 1 zeigt einen schematischen Schaltplan einer ersten Ausführungsform der Erfindung, und

Fig. 2 zeigt einen schematischen Schaltplan einer zweiten Ausführungsform der Erfindung.

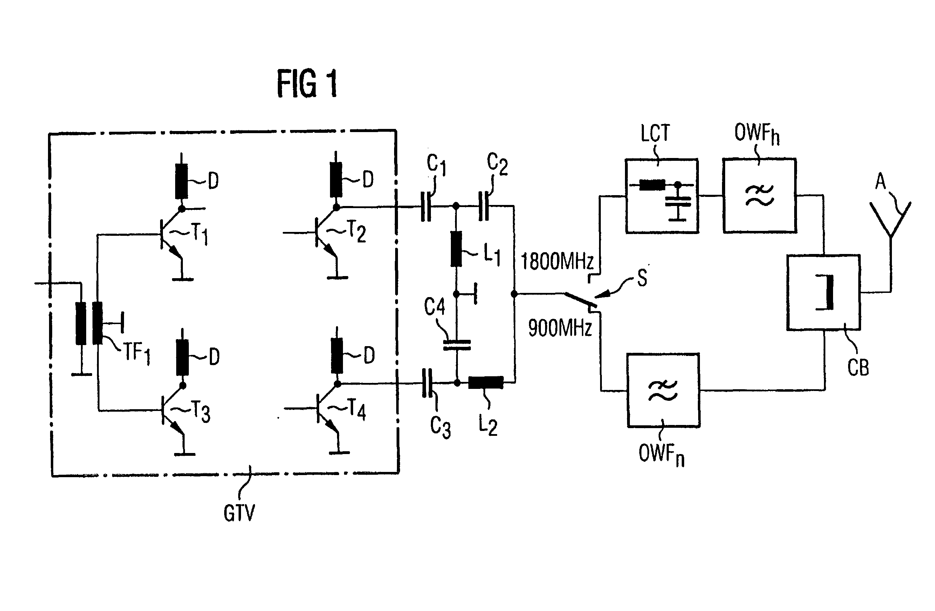

Die bevorzugte Ausführungsform der Fig. 1 zeigt einen schematisch dargestellten Gegentaktverstärker GTV, der einen oberen Zweig, bestehend aus den Transistoren T₁ und T₂, sowie einen unteren Zweig, bestehend aus den Transistoren T₃ und T₄, aufweist, die über einen Transformator oder Übertrager TF mit dem Eingangssignal beaufschlagt werden. Zu jedem Transistor T₁, T₂, T₃ und T₄ ist schematisch jeweils eine Hochfrequenzdrossel D eingezeichnet. Die innere tatsächliche Verschaltung oder Realisierung des Gegentaktverstärkers ist hier nicht von Bedeutung und wird daher nicht ausgeführt. Wesentlich ist nur ,daß der Gegentaktverstärker GTV zwei um 180° phasenverschobene Ausgangsspannungen abgibt. Diese Ausgangssignale werden für den Fall des Betriebs mit 900 MHz über eine Ausgangsanpassung bestehend aus den Kapazitäten C₁ und C₂ sowie einer Induktivität L₁ im oberen Zweig sowie den Kapazitäten C₃ und C₄ und der Induktivität L₂ im unteren Zweig auf einen Schalter S geführt. Die Ausgangsanpassung bewirkt eine Impedanzanpassung sowie eine resultierende Phasendifferenz von 0° der beiden Signale bedingt durch das L-C-Glied L₁, C₂ des oberen Zweiges und das LC-Glied L₄, L₂ des unteren Zweiges. Durch die Verwendung des Gegentaktverstärkers ist die erste Oberwelle, die bei einem Betrieb bei 900 MHz bei 1800 MHz liegt, bereits um 20 bis 30dB unterdrückt. Um die Anforderungen der GSM-Norm bei einem 900 MHz Betrieb vollständig zu erfüllen, wird das Signal über den Schalter S auf einen Oberwellenfilter OWFₙ geführt, der eine entsprechende Filterung vornimmt. Über einen Combiner CB gelangt das Sendesignal auf eine Antenne A.

Bei einem Betrieb der Sendeendstufe mit 1800 MHz wird der Gegentaktverstärker GTV im Eintaktbetrieb betrieben, indem beispielsweise der untere Zweig deaktiviert wird. Dies kann durch Sperren des unteren Zweiges T₃ und T₄ geschehen, beispielsweise indem die Gleichspannungsversorgung des unteren Zweiges abgeschaltet wird oder die Basis beispielsweise des Transistors T₄ (oder T₃) mittels eines PIN-Diodenschalters auf Masse (kurzgeschlossen) gelegt wird. Das Signal des Gegentaktverstärkers GTV im Eintaktbetrieb wird über den durch die Elemente C₁, C₂ und L₁ gebildeten Hochpaß auf den Schalter S durchgereicht, der in der 1800 MHz-Stellung das Signal auf einen L-C-Transformator gibt, der die notwendige Impedanzanpassung an die Antenne A bewirkt. Das Signal wird anschließend in einem Oberwellenfilter OWFₙ für die hohe Frequenz gefiltert, um entsprechend der GSM-Norm die Oberwellen aus dem Signal zu filtern. Über den Combiner CB gelangt das Sendesignal auf die Antenne A.

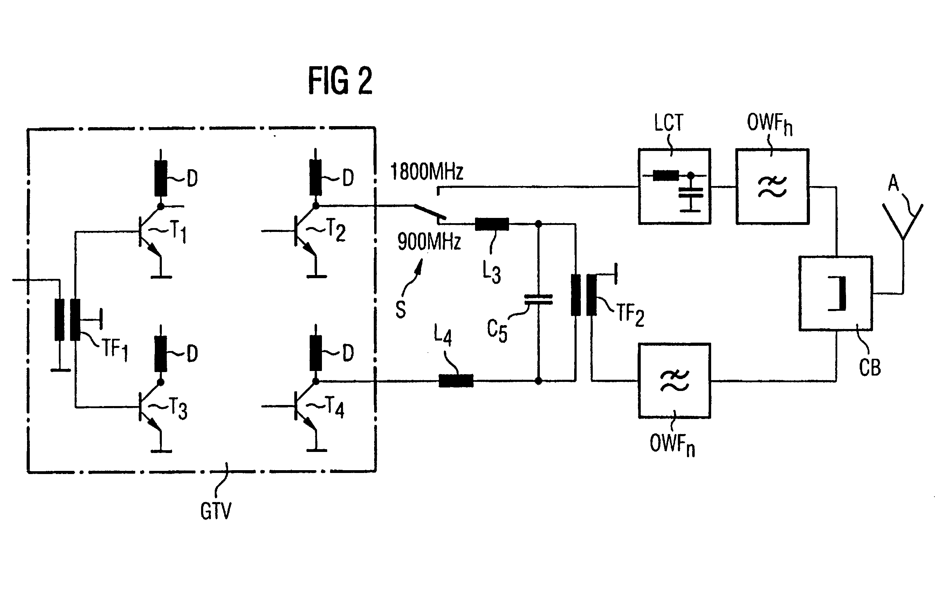

Fig. 2 zeigt eine zweite Ausführungsform der Sendestufe, die sich von der Ausführung der Fig. 1 in der Ausgangsanpassung unterscheidet. Hier gelangen die Ausgangssignale des Gegentaktverstärkers GTV im Fall des Betriebs auf der niederen Frequenz auf einen L-C-Transformator bestehend aus den Induktivitäten L₃ und L₄ sowie der Kapazität C₅, dem ein Gegentaktübertrager TF₂ nachgeschaltet ist, wobei der Schalter S in der unteren Stellung für den 900 MHz-Betrieb steht. Diese Ausgangsanpassung sorgt für die notwendige Impedanzanpassung an die Antenne sowie für eine Phasendifferenz von 0° der Signale, so daß diese vor dem Oberwellenfilter OWFₙ für die niedrige Frequenz phasenrichtig zusammengeführt werden.

Im Fall des Betriebs der Sendeendstufe bei der hohen Frequenz, hier 1800 MHz, wird der Gegentaktverstärker wie in der ersten Ausführungsform der Fig. 1 im Eintaktbetrieb betrieben, und das Ausgangssignal gelangt über den in der Stellung 1800 MHz befindlichen Schalter direkt auf den oberen Zweig bestehend aus einem L-C-Transformator LCT sowie den Oberwellenfilter OWFₕ für die hohe Frequenz.

## Patentansprüche

1. Sendeendstufe für ein Mehrfrequenz-Mobiltelefon bei der das Sendesignal durch eine Gegentaktendstufe (GTV) erzeugt wird,
**dadurch gekennzeichnet, daß** das Sendesignal bei einem Betrieb auf mindestens einer niedrigen Frequenz im Gegentaktbetrieb der Gegentaktendstufe (GTV) erzeugt wird, während das Sendesignal bei einem Betrieb auf mindestens einer höheren Frequenz im Eintaktbetrieb der Gegentaktendstufe (GTV) erzeugt wird.

2. Sendestufe nach Anspruch 1, **dadurch gekennzeichnet, daß** der Eintaktbetrieb erzeugt wird, indem das Signal nur von einem Endtransistor (T₂) ausgekoppelt wird, während der andere Endtransistor (T₄) gesperrt wird.

3. Sendeendstufe nach einem der vorangegangenen Ansprüche, **dadurch gekennzeichnet, daß** Eintaktbetrieb durch Abschalten der Versorgungsspannung oder Abschalten der Transistoren für einen Zweig (T₃, T₄) der Gegentaktendstufe (GTV) erzielt wird.

4. Sendeendstufe nach einem der Ansprüche 1 oder 2, **dadurch gekennzeichnet, daß** in einem Zweig (T₃, T₄) des Gegentaktverstärkers (GTV) ein Schalter angeordnet ist, der ein Kurzschließen dieses Zweigs (T₃, T₄) bewirkt, wenn die Sendeendstufe im Eintaktbetrieb betrieben wird.

5. Sendeendstufe nach Anspruch 4, **dadurch gekennzeichnet, daß** der Schalter ein PIN-Diodenschalter oder ein FET-Schalter ist.

6. Sendeendstufe nach einem der vorangegangenen Ansprüche, **dadurch gekennzeichnet, daß** die Sendeendstufe eine Ausgangsanpasung (C₁, C₂, L₁, C₃, C₄, L₂; L₃, L₄, C₅) aufweist.

7. Sendeendstufe nach Anspruch 6, **dadurch gekennzeichnet, daß** die Sendeendstufe einen Oberwellenf ilter (OWFₙ) für die niedrige Frequenz und einen Oberwellenfilter (OWFₕ) für die hohe Frequenz aufweist, wobei die Sendeendstufe einen Schalter (S) aufweist, der entsprechend der verwendeten Frequenz das Signal bzw. die Signale auf den entsprechenden Oberwellenfilter (OWFₙ, OWFₕ)leitet

8. Sendeendstufe nach Anspruch 7, **dadurch gekennzeichnet, daß** in dem Zweig des Oberwellenfilters (OWFₕ) der hohen Frequenz ein L-C-Transformator (LCT) angeordnet ist.

9. Sendeendstufe nach Anspruch 7, **dadurch gekennzeichnet, daß** in dem Zweig des Oberwellenfilters (OWFₙ) der niedrigen Frequenz ein L-C-Transformator angeordnet ist.

10. Sendeendstufe nach einem der vorangegangenen Ansprüche, **dadurch gekennzeichnet, daß** der Ausgang zur Antenne (a) oder zu einem Antennencombiner (CB) für das hochfrequente Band bei Betrieb auf dem niederfrequenten Band gesperrt wird.

11. Sendeendstufe nach Anspruch 10, **dadurch gekennzeichnet, daß** die Sende stufe zum Sperren des Ausgangs zur Antenne (A) oder zum Antennencombiner (CB) ein Schalter angeordnet ist, der durch einen PIN-Diodenschalter oder ein FET-Schalter realisiert ist.

12. Sendeendstufe nach einem der vorangegangenen Ansprüche, **dadurch gekennzeichnet, daß** als Frequenzen entweder 900 MHz und 1800 MHz oder 900 MHz und 1900 MHz verwendet werden.

## Claims

1. Transmission output stage for a multifrequency mobile telephone in which the transmit signal is generated by a push-pull output stage (GTV), **characterized in that** the transmit signal is generated during operation at at least one low frequency in the push-pull operation of the push-pull output stage (GTV), whereas the transmit signal is generated in single-ended operation of the push-pull output stage (GTV) during operation at at least one higher frequency.

2. Transmission stage according to Claim 1, **characterized in that** the single-ended operation is generated by coupling the signal out of only one output transistor (T₂) whereas the other output transistor (T₄) is cut off.

3. Transmission output stage according to one of the preceding claims, **characterized in that** single-ended operation is achieved by switching off the supply voltage or switching off the transistors for one branch (T₃, T₄) of the push-pull output stage (GTV).

4. Transmission output stage according to either of Claims 1 and 2, **characterized in that**, in one branch (T₃, T₄) of the push-pull amplifier (GTV), a switch is arranged which causes this branch (T₃, T₄) to be short-circuited when the transmission output stage is operated in single-ended mode.

5. Transmission output stage according to Claim 4, **characterized in that** the switch is a PIN diode switch or an FET switch.

6. Transmission output stage according to one of the preceding claims, **characterized in that** the transmission output stage exhibits an output matching circuit (C₁, C₂, L₁, C₃, C₄, L₂; L₃, L₄, C₅).

7. Transmission output stage according to Claim 6, **characterized in that** the transmission output stage exhibits a harmonic filter (OWFₙ) for the low frequency and a harmonic filter (OWFₕ) for the high frequency, the transmission output stage exhibiting a switch (S) which conducts the signal or the signals, respectively, to the appropriate harmonic filter (OWFₙ, OWFₕ) in accordance with the frequency used.

8. Transmission output stage according to Claim 7, **characterized in that** an LC transformer (LCT) is arranged in the branch of the harmonic filter (OWFₕ) of the high frequency.

9. Transmission output stage according to Claim 7, **characterized in that** an LC transformer is arranged in the branch of the harmonic filter (OWFₙ) of the low frequency.

10. Transmission output stage according to one of the preceding claims, **characterized in that** the output to the antenna (A) or to an antenna combiner (CB) for the high-frequency band is blocked during operation in the low-frequency band.

11. Transmission output stage according to Claim 10, **characterized in that** a switch which is implemented by a PIN diode switch or an FET switch is arranged in the transmission stage for blocking the output to the antenna (A) or to the antenna combiner (CB).

12. Transmission output stage according to one of the preceding claims, **characterized in that** either 900 MHz and 1800 MHz or 900 MHz and 1900 MHz are used as frequencies.

## Revendications

1. Etage de sortie pour un téléphone mobile multifréquences, dans lequel le signal d'émission est généré par un étage final symétrique (GTV),
**caractérisé en ce que**
le signal d'émission est généré à une exploitation à au moins une basse fréquence d'exploitation symétrique de l'étage final symétrique (GTV), alors que le signal d'émission est généré à une exploitation à au moins une fréquence plus élevée, en fonctionnement à simple alternance de l'étage final symétrique (GTV).

2. Etage de sortie selon la revendication 1,
**caractérisé en ce que**
le fonctionnement à simple alternance est généré **en ce que** le signal est uniquement découplé par un transistor de sortie (T₂), alors que l'autre transistor de sortie (T₄) est bloqué.

3. Etage de sortie selon l'une quelconque des revendications précédentes,
**caractérisé en ce que**
le fonctionnement à simple alternance est obtenu par déconnexion de la tension d'alimentation ou par déconnexion des transistors pour une branche (T₃, T₄) de l'étage final symétrique (GTV).

4. Etage de sortie selon l'une quelconque des revendications 1 ou 2,
**caractérisé en ce que**,
un commutateur provoquant une mise en court-circuit de ladite branche (T₃, T₄), lorsque l'étage final symétrique est exploité en fonctionnement à simple alternance, est disposé dans une branche (T₃, T₄). de l'amplificateur symétrique (GTV).

5. Etage de sortie selon la revendication 4,
**caractérisé en ce que**
le commutateur est un circuit à diodes PIN ou un commutateur TEC.

6. Etage de sortie selon l'une quelconque des revendications précédentes,
**caractérisé en ce que**
l'étage final symétrique présente une adaptation de sortie (C₁, C₂, L₁, C₃, C₄, L₂, L₃, L₄, C₅).

7. Etage de sortie selon la revendication 6,
**caractérisé en ce que**
l'étage final symétrique présente un filtre d'harmoniques (OWFₙ) pour la basse fréquence et un filtre d'harmoniques (OWFₕ) pour la haute fréquence, les étages de sortie présentant un commutateur (S), qui en fonction de la fréquence utilisée, conduit le signal ou les signaux vers le filtre d'harmoniques correspondant (OWFₙ, OWFₕ).

8. Etage de sortie selon la revendication 7,
**caractérisé en ce que**
un transformateur L-C (LCT) est disposé dans la branche du filtre d'harmoniques (OWF_{H}) pour la haute fréquence.

9. Etage de sortie selon la revendication 7,
**caractérisé en ce que**
un transformateur L-C est disposé dans la branche du filtre d'harmoniques (OWFₙ) de la basse fréquence.

10. Etage de sortie selon l'une quelconque des revendications précédentes,
**caractérisé en ce que**
la sortie vers l'antenne (a) ou vers un combineur d'antennes (CB) pour la bande à haute fréquence est bloquée lors d'une exploitation sur la bande à basse fréquence.

11. Etage de sortie selon la revendication 10,
**caractérisé en ce que**
dans l'étage d'émetteur pour le blocage de la sortie vers l'antenne (A) ou vers le combineur d'antenne (B) un commutateur, réalisé par un circuit à diodes PIN ou par un commutateur TEC est disposé.

12. Etage de sortie selon l'une quelconque des revendications précédentes,
**caractérisé en ce que** les fréquences utilisées sont soit 900 MHz et 1800 MHz ou 900 MHz et 1900 MHz.
